# EUROPEAN PATENT APPLICATION

(11) **EP 4 770 397 A1**
(43) Date of publication of application: **01.07.2026**
(21) Application number: 25227429.5
(22) Date of filing: 29.12.2025
(51) Int. Cl.: H10K 59/80, H10K 59/65

(54) **LIGHT EMITTING DISPLAY DEVICE**

(30) Priority: 30.12.2024 KR 20240200910
(71) Applicant: LG Display Co., Ltd., Seoul, 07336 (KR)
(72) Inventor: YANG, Jung Yul, 10845 Paju-si (KR); LEE, Jun Ho, 10845 Paju-si (KR); CHOI, Sun Young, 10845 Paju-si, (KR); YEO, Jong Hoon, 10845 Paju-si (KR)
(74) Representative: Ter Meer Steinmeister & Partner

(57) **Abstract**

A light emitting display device according to an embodiment of the present disclosure may comprise a substrate including an active area having a hole and a non-active area surrounding the active area, a plurality of subpixels in the active area, the plurality of subpixels spaced apart from the hole by a first distance, a transistor at each of the plurality of subpixels, a light-emitting element including a first electrode provided at each of the plurality of subpixels and connected to the transistor, a second electrode facing the first electrode, and an intermediate layer interposed between the first electrode and the second electrode and a dam region to surround the hole within the first distance, the dam region including a bank material layer having an undercut.

The dam region may comprise at least one light-shielding material among the bank material layer and an upper structure overlapping the bank material layer.

## Description

This application claims the benefit of Korean Patent Application No. 10-2024-0200910, filed on December 30, 2024.

### BACKGROUND OF THE DISCLOSURE

### Field of the Disclosure

The present disclosure relates to a display device having a structure with a hole in which components around the hole have improved reliability.

### Discussion of the Related Art

Display devices that display images on TVs, monitors, smartphones, tablets, and laptops are being used in various manners and forms.

A display device includes a plurality of pixels to display an image and has transistors to control the operation of each pixel. In addition, transistors formed through the same process as transistors provided in pixels are also provided in a non-active area around the pixels.

Among display devices, a light emitting display device that does not have a separate light source and has light emitting elements within a display panel for compactness of the device and clear color display is being considered as a competitive application.

Meanwhile, display devices have recently been equipped with sensors for various purposes. To easily collect external light for sensors, a substrate is removed in full thickness or in part in a hole area of the substrate.

### SUMMARY OF THE DISCLOSURE

Accordingly, an object of the present disclosure is directed to a light emitting display device that substantially obviates one or more problems due to limitations and disadvantages of the related art.

An object of the present disclosure is to provide a light emitting display device capable of preventing influence of external air through a hole in a substrate and improving the reliability of subpixels, e.g. by changing the structures of components between the hole provided in an active area in a substrate and subpixels.

An object of the present disclosure is to provide a light emitting display device having elements including transistors with improved reliability.

An object of the present disclosure is to provide a light emitting display device capable of preventing influence of external light incident through a hole in a substrate on components around the hole.

An object of the present disclosure is to provide a display device optimized for processes by reducing manufacturing process costs, shortening manufacturing process time, and/or reducing production energy and greenhouse gas emission.

At least one of these objects is solved by the features of the independent claim. Additional advantages, aspects, and features of the present disclosure will be set forth in part in the description which follows and in part will become apparent to those having ordinary skill in the art upon examination of the following or may be learned from practice of the present disclosure. The aspects and other advantages of the present disclosure may be realized and attained by the structure particularly pointed out in the written description and claims hereof as well as the appended drawings.

According to an aspect of the present disclosure, a light emitting display device comprises a substrate including an active area having a hole and a non-active area surrounding the active area, a plurality of subpixels in the active area, the plurality of subpixels spaced apart from the hole by a first distance, a transistor at each of the plurality of subpixels, a light-emitting element including a first electrode provided at each of the plurality of subpixels and connected to the transistor, a second electrode facing the first electrode, and an intermediate layer interposed between the first electrode and the second electrode and a dam region to surround the hole within the first distance, the dam region including a bank material layer having an undercut.

The dam region may comprise at least one light-shielding material among the bank material layer and an upper structure overlapping the bank material layer.

It is to be understood that both the foregoing general description and the following detailed description of the present disclosure are exemplary and explanatory and are intended to provide further explanation of the present disclosure as claimed.

### BRIEF DESCRIPTION OF THE DRAWINGS

The accompanying drawings, which are included to provide a further understanding of the present disclosure and are incorporated in and constitute a part of this application, illustrate embodiment(s) of the present disclosure and together with the description serve to explain the principle of the present disclosure. In the drawings:
FIG. 1 is a plan view showing a light emitting display device according to an embodiment of the present disclosure;
FIG. 2 is an enlarged plan view of area A of FIG. 1;
FIG. 3 is an enlarged view of area B of FIG. 2;
FIG. 4 is a circuit diagram of a subpixel;
FIG. 5 is a cross-sectional view of the light emitting display device according to an embodiment of the present disclosure, taken along line I-I' in FIG. 2;
FIG. 6A to FIG. 6F are cross-sectional views showing a process of a method of forming a bank material layer of a dam of the light emitting display device according to the present disclosure; and
FIG. 7 to FIG. 10 are cross-sectional views of light emitting display devices according to other embodiments of the present disclosure, taken along line I-I' in FIG. 2.

### DETAILED DESCRIPTION OF THE DISCLOSURE

The advantages and features of the present disclosure and the way of attaining the same will become apparent with reference to embodiments described below in detail in conjunction with the accompanying drawings. The present disclosure, however, is not limited to the embodiments disclosed hereinafter and may be embodied in many different forms. Rather, these exemplary embodiments are provided so that the present disclosure will be through and complete and will fully convey the scope to those skilled in the art. Thus, the scope of the present disclosure should be defined by the claims.

The same or extremely similar elements are designated by the same reference numerals throughout the specification, and in the drawings, the lengths and thickness of layers and regions may be exaggerated for convenience. The scale of the components shown in the drawings is different from the actual scale, and is not limited to the scale shown in the drawings.

It will be understood that, when a certain element (or a region, a layer, or a portion) is referred to as being "on", "connected to" or "combined with" another element, the element may be directly connected/combined to/with the other element, or a third element may be interposed therebetween.

"And/or" includes any combination of one or more of the associated components.

While terms, such as "first", "second", etc., may be used to describe various components, such components must not be limited by the above terms. The above terms are used only to distinguish one component from another. In addition, terms particularly defined in consideration of construction and operation of the embodiments are used only to describe the embodiments and do not define the scope of the embodiments.

In the description of the embodiments, it will be understood that, when an element is referred to as being formed "on" or "under" another element, it can be directly "on" or "under" the other element or be indirectly formed with intervening elements therebetween. It will also be understood that, when an element is referred to as being "on" or "under", "under the element" as well as "on the element" can be included based on the element.

It will be further understood that the terms "comprise" and "include" specify the presence of stated features, integers, steps, operations, elements, components, and/or combinations thereof, but do not preclude the presence or addition of one or more other features, integers, steps, operations, elements, components, and/or combinations.

The respective features of the various embodiments of the present disclosure may be partially or wholly coupled to and combined with each other, and various technical linkage and driving thereof are possible. These various embodiments may be performed independently of each other, or may be performed in association with each other.

Hereinafter, a display device of the present disclosure will be described with reference to the attached drawings and embodiments.

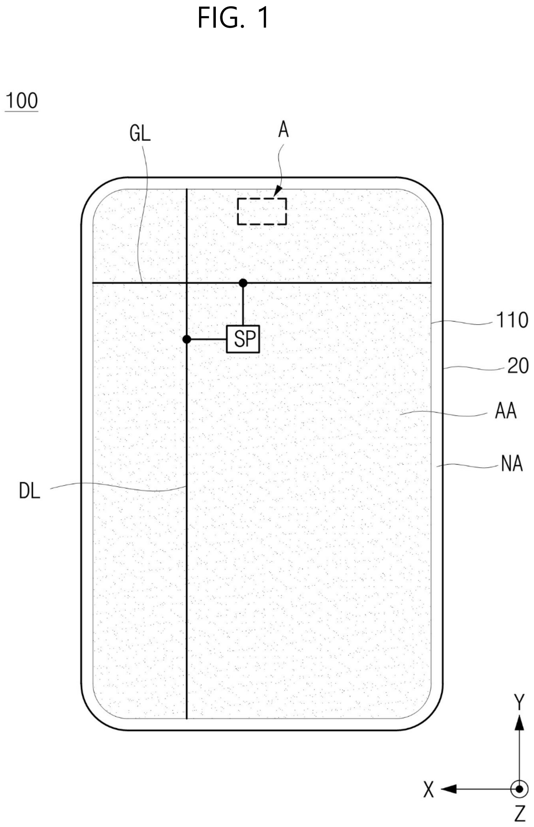

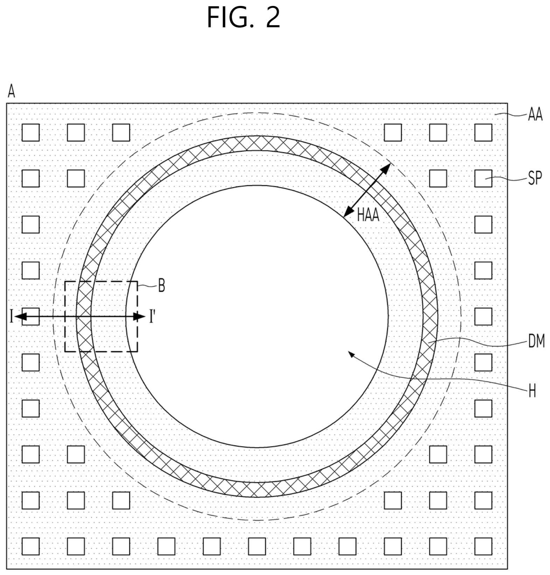

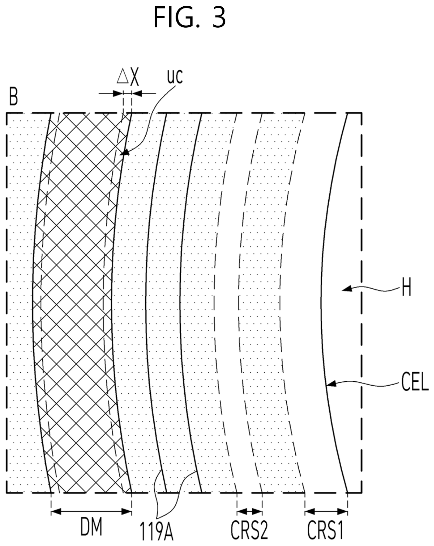

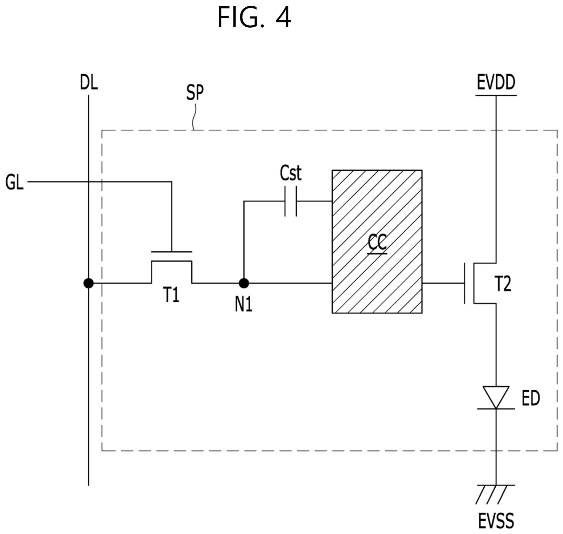

FIG. 1 is a plan view showing a light emitting display device according to an embodiment of the present disclosure. FIG. 2 is an enlarged plan view of area A of FIG. 1. FIG. 3 is an enlarged view of area B of FIG. 2. FIG. 4 is a circuit diagram of a subpixel.

Referring to FIG. 1, the display device 100 according to an embodiment of the present disclosure includes a display panel 110 having an active area AA and a non-active area NA and a cover member 20 disposed on the display panel 110.

The cover member 20 is disposed on the display panel 110 to cover the front surface of the display panel 110 and protect the display panel 110 from external impact. The edge of the cover member 20 may have a curved portion or a curved surface portion that is bent in the direction (-Z-axis direction) of the back of the display device 100. Accordingly, the cover member 20 can also cover the side area of the display panel 110, and thus the display panel 110 can be protected from external impact not only on the front face but also on the side of the display device 100.

The active area AA of the display device 100 is an area that displays an image, and an area other than the active area AA is a non-active area NA. The active area AA and the non-active area NA of the display device 100 may be applied equally to the display panel 110.

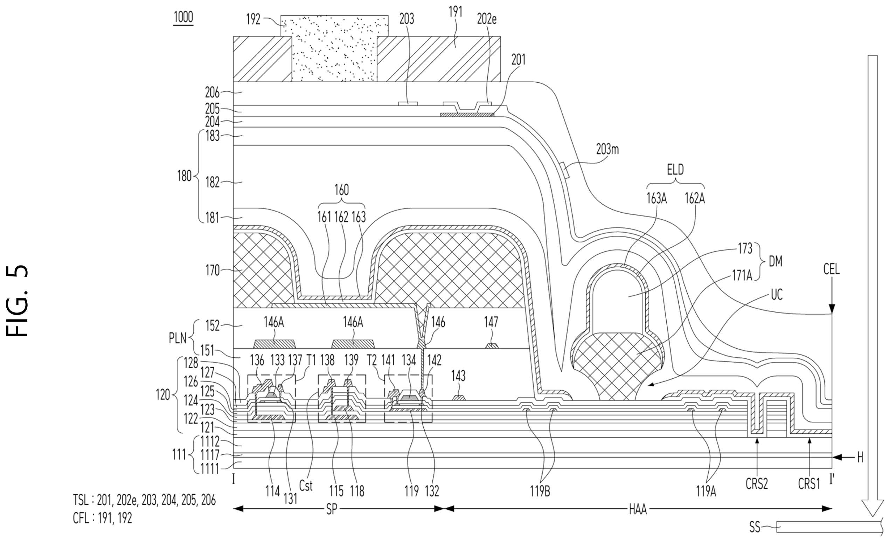

The display device 100 includes a substrate (111 in FIG. 5) having the active area AA and the non-active area NA. A plurality of data lines DL extending in a first direction Y and a plurality of gate lines GL extending in a second direction X intersecting the first direction may be disposed in the active area AA on the substrate.

Subpixels SP may be disposed at intersections of the data lines DL and the gate lines GL. Each subpixel SP may be defined as an emission area and is not limited to the intersections of the data lines DL and the gate lines GL. That is, emission areas may intersect the data lines and/or the gate lines GL.

The subpixels SP may emit white light W, or may respectively emit red light R, green light G, and blue light B. Where the subpixels SP emit white light, a color filter layer may be additionally provided over the subpixels SP emitting light is to express colors corresponding to the subpixels.

As shown in FIG. 2, the active area AA may have a hole H in the substrate (111 in FIG. 5) in an area where a camera or a sensor is provided. The area of the substrate 111 corresponding to the hole H is removed in full thickness or in part to form the hole H. The camera or sensor may be disposed to overlap the hole H of the substrate 111. The camera or sensor may be located on the lower side of the substrate 111, at least a light receiving part of the camera or sensor may be disposed above the hole H, and module components surrounding the light receiving part of the camera or sensor may be disposed to overlap the substrate 111 around the hole.

The end line CEL of the hole H is located at the boundary between the area where the hole H is provided and the area of the substrate 111 outside the hole H.

The hole H of the substrate 111 is provided in the active area AA of the substrate 111, and subpixels SP are disposed around the hole H.

In the display device of the embodiments of the present disclosure, as shown in FIG. 2 and FIG. 3, in order to prevent or suppress damage caused by removal of the substrate 111 and components on the substrate 111 from affecting the subpixels SP, the subpixels SP may be disposed having a first distance HAA away from the end line CEL of the hole H.

An encapsulation layer (180 in FIG. 5) protects a light-emitting element ED. The encapsulation layer may be provided at each subpixel SP may be provided. Inorganic encapsulation layers (181 and 183 in FIG. 5) included in the encapsulation layer 180 is disposed over the subpixels SP and can be extended to the first distance HAA away from the end line CEL of the hole H. An edge of at least one inorganic encapsulation layer (181, 183 in FIG. 5) can be positioned at the end line CEL of the hole H in the active area AA. Within the first distance HAA, a dam DM defining a disposition area of an organic encapsulation layer (182 in FIG. 5) included in the encapsulation layer (180 in FIG. 5) may be provided.

A region in which the dam DM is positioned on the substrate 111 can be defined as a dam region. A width of the dam region may be a same width as a width of the dam DM. The dam region having the dam DM is disposed within the first distance HAA surrounding the hole H. The dam DM prevents or block the organic encapsulation layer from overflowing into the hole H, and prevents the thick organic encapsulation layer from overlapping the end line CEL of the hole H, thereby allowing the process of removing the area of the substrate corresponding to the hole H to be easily performed. The dam region includes at least the dam DM.

A plurality of wiring layers 119A and 119B may be provided inside or outside the dam DM. The plurality of wiring layers 119A and 119B may be provided around the hole H, as shown in FIG. 3 and FIG. 5. The wiring layer 119A may be disposed between the dam DM and the hole H, and may be disposed in a circular shape around the hole H along the dam DM. The wiring layers 119A and 119B on the inner and outer sides of the dam DM may extend from a circular shape surrounding the hole H to the subpixels SP around the hole H and include gate lines for supplying a gate signal to the subpixels SP or data lines for supplying a data signal to the subpixels SP.

As shown in FIG. 3, the dam region including the dam DM or the dam DM may have an undercut UC (refer to FIG. 5) with a width of approximately ΔX at both edges of the dam DM. The undercut UC is provided by etching the lower portion of the dam DM more than the upper portion such that a side edge of the lower portion is positioned farther inward than the upper portion of the dam DM. The light-emitting element ED (e.g., 160 in FIG. 5) includes a first electrode (e.g., 161 in FIG. 5), an intermediate layer (e.g., 162 in FIG. 5), and a second electrode (e.g., 162 in FIG. 5), and includes at least an organic material. The intermediate layer includes an emission layer and/or functional layers, and at least one or each layer may be formed by depositing an evaporated organic material. In this case, the deposition process is performed by arranging a deposition material supply source that supplies a deposition material in the form of vapor at the lower side of a chamber, positioning the substrate at the upper side of the chamber, and arranging a deposition material formation portion of the substrate to face the deposition material supply source. Here, since the intermediate layer has poor step coverage characteristics in a deposition step, the intermediate layer 162 is not deposited on a lower portion of the dam DM which overlaps the undercut UC, thus resulting in one or more disconnections in the intermediate layer 162. Relatively, deposition of the deposition material can be performed normally on an upper surface of the dam DM on which an opening part of a deposition mask directly faces in the vertical direction in the deposition process.

In an embodiment of the present disclosure, the undercut UC may be positioned at a part of the dam DM. In another embodiment of the present disclosure, the undercut UC may be entirely positioned at a side of the dam DM or both sides of the dam DM.

In the embodiments of the present disclosure, the dam region including the dam DM may comprise at least one of a planarization layer (e.g., 151 and/or 152 in FIG. 5), a bank material layer (e. g. , 171A in FIG. 5), and a spacer material layer (e. g. , 173 in FIG. 5). At the dam region, each of the planarization layer, the bank material layer, and the spacer material layer may have a certain thickness or more, and thus the dam DM may have a sufficient thickness. At the dam region, the dam DM prevents overflow of the organic encapsulation layer (e.g., 180 in FIG. 5). The dam DM may have a width of 5 µm to 30 µm. In this case, the undercut of the dam DM may also have a sufficient width of 1 µm or more. Therefore, a stable undercut area can be secured, and intermediate layer disconnection can be secured through the single dam.

Compared to the undercut of the dam DM, in an undercut structure using a wiring line and components thereunder, if the wiring line is narrow and the undercut is located at the edge of the wiring line, the undercut is also narrow. However, an undercut area using a plurality of wiring layers is required for sufficient intermediate layer disconnection around the hole H. In this case, the first distance HAA used as a margin area around the hole may increase in order to provide a plurality of wiring layers, and thus the effective pixel area in which the subpixels are disposed may decrease.

In the display device according to the embodiment of the present disclosure, an undercut area of sufficient width and height can be provided at at least one side of the dam region by using a structure of the dam DM. Furthermore, the undercut shape is stable without collapsing. Since the intermediate layer of the light-emitting element can be stably disconnected at at least one side of the dam region, even if external air or moisture is introduced through the hole H, the intermediate layer of the subpixels SP around the hole H can be disconnected, thereby solving or mitigating the problem of moisture permeation through the intermediate layer.

At least a part of the intermediate layer of the light-emitting element is not provided at the undercut UC. At least the part of the intermediate layer (162 in FIG. 5) of the light-emitting element ED provided at the subpixels SP can be disconnected from a dummy intermediate layer 162A at the dam region having the dam DM. Accordingly, the intermediate layer 162 over the subpixel SP is separated from a dummy intermediate layer (162A in FIG. 5) on the dam DM in the first distance HAA from the end line CEL of the hole H. The dummy intermediate layer 162A between the hole H and the dam DM is separated from the intermediate layer 162 at the subpixels SP.

Crack prevention parts CRS1 and CRS2 may be further provided to surround the end line CEL of the hole H inside the dam DM.

The crack prevention parts CRS1 and CRS2 may be formed by removing a plurality of inorganic insulating layers included in a transistor array on the substrate 111. Inorganic insulating layers are harder than organic insulating layers. When a laser or the like is radiated to the end line CEL of the hole H to form the hole H of the substrate 111, if a plurality of inorganic insulating layers is disposed on the end line CEL of the hole H, a crack may propagate through the inorganic insulating layers around the end line CEL of the hole. The display device of the embodiments of the present disclosure may include the first crack prevention part CRS1 in contact with the end line CEL of the hole H and the second crack prevention part CRS2 spaced apart from the first crack prevention part CRS1, thereby preventing physical impact applied to the substrate 111 when the hole H is formed from being transmitted in the horizontal direction. In some cases, the crack prevention parts CRS1 and CRS2 may be provided as a single part, or may be provided as components spaced apart from each other as illustrated. The crack prevention parts CRS1 and CRS2 and the dam DM are located within the first distance HAA from the end line CEL of the hole H of the substrate 111.

Meanwhile, in the display device of the embodiments of the present disclosure, the dam DM may include an organic insulating material such as a bank material layer having at least a certain thickness. In addition, the dam DM may be disposed at a distance from the end line CEL of the hole H. In the process of forming the organic encapsulation layer 182 included in the encapsulation layer (180 in FIG. 5) located over the subpixels SP, when a liquid organic material is applied onto the substrate 111, the liquid organic material cannot overflow into the hole H over the dam DM having a certain height. The formation of the encapsulation layer 180 may be performed before the formation of the hole H of the substrate 111.

Each subpixel SP may be disposed between a gate line GL and a data line DL that intersect each other, as shown in FIG. 4, and may include a first transistor T1, a second transistor T2, a storage capacitor Cst, a compensation circuit CC, and a light-emitting element ED.

For example, the first transistor T1 may be a switching transistor, and the second transistor T2 may be a driving transistor.

The first transistor T1 is electrically connected to the data line DL and electrically connected to a first node N1. The gate electrode of the first transistor T1 is electrically connected to the gate line GL. The first transistor T1 transmits a data signal supplied through the data line DL to the first node N1 in response to a scan signal supplied through the gate line GL.

The storage capacitor Cst is electrically connected to the first node N1 and is charged with a voltage applied to the first node N1.

The second transistor T2 receives a high-level driving voltage EVDD and is electrically connected to a first electrode (e.g., anode) of the light-emitting element ED. The second transistor T2 can control the amount of driving current flowing through the light-emitting element ED in response to a voltage applied to the gate electrode thereof.

Semiconductor layers of the first transistor T1 and the second transistor T2 may include an oxide semiconductor material such as IGZO (Indium-Gallium-Zinc-Oxide).

The light-emitting element ED emits light corresponding to the driving current supplied from the second transistor T2. The light-emitting element ED may emit light of one of red, green, blue, and white.

The light-emitting element ED may include the first electrode, an intermediate layer disposed on the first electrode, and a second electrode supplying a common voltage. The intermediate layer includes an emission layer and various functional layers, and may emit light of the same color for subpixels, such as white light, or may emit a different color for each subpixel SP, such as red, green, or blue light. The functional layers may include a hole injection layer, a hole transport layer, an electron transport layer, an electron injection layer, and a charge generation layer. The intermediate layer may include a plurality of stacks, and the plurality of stacks may include a charge generation layer between adjacent stacks to facilitate supply of holes and electrons between the stacks. Each of the stacks may include at least one emission layer, a hole transport layer, and an electron transport layer.

The first electrode may serve as an anode, and the second electrode may serve as a cathode. The light-emitting element ED is substantially the same as the light-emitting element (160 in FIG. 5) which will be described below.

The compensation circuit CC may be provided in a first subpixel SP1 to compensate for the threshold voltage of the second transistor T2. The compensation circuit CC may be composed of one or more transistors. The compensation circuit CC may include one or more transistors and a capacitor, and may be configured in various manners depending on the compensation method. A pixel including the compensation circuit CC may have various structures such as 3T1C, 4T2C, 5T2C, 6T1C, 6T2C, 7T1C, and 7T2C. For example, a plurality of transistors may be electrically connected between the second transistor T2 and the light-emitting element ED.

Although the configuration in which the second transistor T2 and the light-emitting element ED are directly connected is shown in FIG. 4, the present disclosure is not limited thereto. Depending on the form of the compensation circuit CC, the subpixel SP may further include another transistor or compensation capacitor between the light-emitting element ED and the second transistor T2 that generates a driving current.

Hereinafter, light emitting display devices according to various embodiments of the present disclosure will be described.

FIG. 5 is a cross-sectional view of a light emitting display device according to an embodiment of the present disclosure, taken along line I-I' in FIG. 2.

As shown in FIG. 1 to FIG. 5, the light emitting display device according to an embodiment of the present disclosure includes the substrate 111 having an active area (AA in FIG. 1) having the hole H and a non-active area NA surrounding the active area NA.

The light emitting display device 1000 according to an embodiment of the present disclosure includes a plurality of subpixels SP provided in the active area AA spaced apart from the hole H by at least the first distance HAA, transistors T1 and T2 provided at each of the plurality of subpixels SP, and a light-emitting element 160 connected to at least one of the transistors T1 and T2.

As shown in FIG. 5, the light emitting display device according to the present embodiment includes the dam DM including a bank material layer 171A having a cross section of an undercut UC and surrounding the hole H within the first distance HAA. The dam DM is positioned at the dam region on the substrate 111. In the embodiment of FIG. 5, the dam region includes the dam DM at least having a light-shielding material. The bank material layer 171A of the dam DM may comprise same material as a bank 170 defining an emission area of each light-emitting element 160 provided at each subpixel SP. The bank material layer 171A and the bank 170 may comprise the light-shielding material.

The light-emitting element 160 includes a first electrode 161, an intermediate layer 162, and a second electrode 163.

The emission area of the light-emitting element 160 is provided in an opening of the bank 170. The bank 170 may comprise, for example, a light-shielding organic material to cover a non-emission area between adjacent subpixels SP, and prevent light emitted from each subpixel SP from being incident on an adjacent subpixel SP as oblique light to prevent mixing of colors. In addition, when external light is incident from above, the bank 170 can reduce or prevent reflection on the surface of the first and second electrodes 161 and 163 overlapping the bank 170, thereby preventing external light from being visible.

The bank material layer 171A of the dam DM located at a same layer as the bank 170 is made of a light-shielding organic material in an embodiment of FIG. 5. Thus, when external light is received by a sensor SS on the lower side of the substrate 111 through the hole H, even if some of the external light enters the hole H from the side, the light-shielding material of the dam DM can block propagation of the light from the side. Accordingly, by disposing the bank material layer 171A made of the light-shielding organic material around the first distance HAA, when external light entering through the hole H propagates, the bank material layer 171A made of the light-shielding organic material primarily blocks emission of light, thereby blocking inflow of light from the side into the transistors T1 and T2 at the subpixel SP. Accordingly, stability of the elements of the transistors T1 and T2 can be maintained.

The substrate 111 is made of a flexible material, and may be easily removed when a laser is radiated to the substrate 111 to form the hole H. For example, the substrate 111 may comprise first and second organic layers 1111 and 1112 that overlap each other with an inorganic interlayer insulating layer 1117 therebetween. The inorganic interlayer insulating layer 1117 may block transfer of moisture or impurities between the first and second organic layers 1111 and 1112. The inorganic interlayer insulating layer 1117 is disposed on the first organic layer 1111 and may include a partially patterned structure. The inorganic interlayer insulating layer 1117 may include at least one of a silicon nitride layer, a silicon oxide layer, or a silicon oxynitride layer.

The first and second organic layers 1111 and 1112 may include, for example, polyimide. In addition to polyimide, the first and second organic layers 1111 and 1112 may include different organic layers.

The substrate 111 may include a PET (polyethylene terephthalate) layer as one of the first and second organic layers 1111 and 1112 and a polyimide layer as the other.

As another example, the substrate 111 may include a thin glass material having flexibility.

The substrate 111 serves to support and protect components of the light emitting display device arranged thereon.

A plurality of laminated insulating layers 120 (121, 122, 123, 124, 125, 126, 127, and 128) and planarization layers 151 and 152 are disposed in the active area AA and the non-active area NA of the substrate 111 such that active layers 131 and 132 and the gate electrodes 133 and 134 of the transistors T1 and T2 can be insulated from each other, the gate electrodes 133 and 134 and the source-drain electrodes 137, 141, and 142 can be insulated from each other, and a first storage electrode 115 and a second storage electrode 118 constituting the storage capacitor Cst can be insulated from each other.

The first transistor T1 includes, for example, a first light-shielding pattern 114, the first active layer 131, the first gate electrode 133, and the source-drain electrode 137. The first light-shielding pattern 114 is connected to the first gate electrode 133 disposed on the first active layer 131 through a connection electrode 136 to serve as a double gate. In this case, the same voltage is applied to the first light-shielding pattern 114 and the first gate electrode 133.

The second transistor T2 includes, for example, a second light-shielding pattern 119, the second active layer 132, the second gate electrode 134, the first source-drain electrode 141, and the second source-drain electrode 142.

The storage capacitor Cst includes the first storage electrode 115 and the second storage electrode 118 that overlap each other with a fourth insulating layer 124 interposed therebetween. The first storage electrode 115 and the second storage electrode 118 may be connected to first and second connection electrodes 138 and 139 disposed thereabove, which are provided as metal layers and located on the same layer as the source-drain electrodes 137, 141, and 142 of the first and second transistors T1 and T2.

The second transistor T2 may be connected to the first electrode 161 of the light-emitting element ED through a connection electrode 146.

As shown in FIG. 3, the wiring layer 119A parallel to the dam DM may be further provided in the area of the dam DM having the first distance HAA from the end line CEL of the hole H, and as shown in FIG. 5, wiring layers 119B, 143, and 147 parallel to the dam DM may be further provided between the dam DM and the subpixels SP.

The wiring layer 119A located inside the area surrounded by the dam DM and the wiring layer 119B located outside the area surrounded by dam DM may be located in the same layer as any one of the light-shielding patterns 114 and 119, the active layers 131 and 132, the gate electrodes 133 and 134, the source-drain electrodes 137, 141, and 142, and the connection electrode 146 of the transistors T1 and T2.

A metal layer 146A overlapping the first transistor T1 and the storage capacitor Cst may be further provided in the same layer as the connection electrode 146. The metal layer 146A may prevent the operation of the first transistor T1 or the storage capacitor Cst from causing electrical interference for the light-emitting element 160.

The insulating layer 120 may include, for example, a first insulating layer 121, a second insulating layer 122, a third insulating layer 123, a fourth insulating layer 124, a fifth insulating layer 125, a sixth insulating layer 126, a seventh insulating layer 127, and an eighth insulating layer 128. The insulating layer 120 may include an inorganic insulating material.

The crack prevention parts CRS1 and CRS2 may be disposed adjacent to the end line CEL of the hole H by removing all or some of the first to eighth insulating layers 121 to 128. The crack prevention parts CRS1 and CRS2 may have a circular shape having a larger diameter than the hole H and surround the hole H in a plane. The crack prevention parts CRS1 and CRS2 can block or disperse shocks applied to the end line CEL of the hole H, when the hole is formed, from being transmitted in the horizontal direction through an inorganic insulating layer.

The first insulating layer 121 is disposed in the active area AA and the non-active area NA on the substrate 111. The first insulating layer 121 may be a buffer layer and may have the same function as a buffer layer known in the art. The first insulating layer 121 may be disposed on the substrate 111 to protect structures located on the substrate 111 from moisture penetrating through the substrate 111 and may planarize the surface of the substrate 111. The first insulating layer 121 may include a plurality of inorganic insulating layers.

The first insulating layer 121 may extend to the edge of the non-active area NA of the substrate 111 to prevent moisture from penetrating from the edge of the substrate 111. The first insulating layer 121 may be a single inorganic layer or may be composed of a plurality of alternately-laminated inorganic layers.

For example, the first insulating layer 121 may include one or more inorganic layers among a silicon oxide (SiOx) layer, a silicon nitride (SiNx) layer, and a silicon oxynitride (SiOxNy) layer, or may include a laminate thereof.

The second insulating layer 122 may be disposed on the first insulating layer 121. The second insulating layer 122 may be, for example, a second buffer layer. Polysilicon transistors having an active layer made of crystalline silicon may be provided as transistors provided on the substrate 111. In this case, the second insulating layer 122 may stabilize and planarize the formation surface of the active layer including crystalline silicon. The second insulating layer 122 may include an inorganic layer, for example, a silicon oxide (SiOx) layer, a silicon nitride (SiNx) layer, or a laminate thereof.

The third insulating layer 123 may be provided on the second insulating layer 122. The third insulating layer 123 may be a gate insulating layer of a transistor including an active layer made of crystalline silicon.

The first light-shielding pattern 114 of the first transistor T1 and the first storage electrode 115 of the storage capacitor Cst may be provided on the third insulating layer 123. The first light-shielding pattern 114 and the first storage electrode 115 may comprise, for example, a conductive metal material. Specifically, the conductive metal material may include at least one of an aluminum-based metal such as aluminum (Al) or an aluminum alloy, a silver-based metal such as silver (Ag) or a silver alloy, a copper-based metal such as copper (Cu) or a copper alloy, a molybdenum-based metal such as molybdenum (Mo) or a molybdenum alloy, chromium (Cr), tantalum (Ta), neodymium (Nd), and titanium (Ti).

The fourth insulating layer 124 may be disposed on the third insulating layer 123. The fourth insulating layer 124 may serve as an insulator between the first and second storage electrodes 115 and 118, and may also function as an interlayer insulating layer of a transistor including an active layer made of polycrystalline silicon.

The fourth insulating layer 124 may include an inorganic material. The inorganic material may include, for example, silicon nitride (SiNx).

The second storage electrode 118 may be disposed on the fourth insulating layer 124 and include a conductive metal material. Specifically, the conductive metal material may include at least one of an aluminum-based metal such as aluminum (Al) or an aluminum alloy, a silver-based metal such as silver (Ag) or a silver alloy, a copper-based metal such as copper (Cu) or a copper alloy, a molybdenum-based metal such as molybdenum (Mo) or a molybdenum alloy, chromium (Cr), tantalum (Ta), neodymium (Nd), or titanium (Ti).

The first storage electrode 115 and the second storage electrode 118 may each be a single layer or may be a laminate of multiple different metal materials.

The fifth insulating layer 125 may be disposed on the fourth insulating layer 124.

The second light-shielding pattern 119 of the second transistor T2 may comprise a conductive metal material and disposed on the fifth insulating layer 125. The conductive metal material may be, for example, a metal. The second light-shielding pattern 119 may be a single metal, or may be made of two or more types of metals or an alloy of two or more types of metals. In addition, the second light-shielding pattern 119 may be a single layer or multiple layers.

The sixth insulating layer 126 may be disposed on the fifth insulating layer 125 to cover the second light-shielding pattern 119.

The fifth insulating layer 125 and the sixth insulating layer 126 are located below the first and second active layers 131 and 132 and may serve as a buffer layer.

The first and second transistors T1 and T2 may include the first and second active layers 131 and 132 that are oxide semiconductor layers. Where the active layers comprise the oxide semiconductor layers, off characteristics can be stabilized and mobility of a certain level or higher can be secured.

The fifth insulating layer 125 and the sixth insulating layer 126 may serve to planarize the formation surface of the first and second active layers 131 and 132 made of oxide semiconductor disposed thereon.

The fifth insulating layer 125 and the sixth insulating layer 126 may include an inorganic layer. The inorganic layer may include, for example, a silicon oxide (SiOx) layer or a laminate of inorganic layers.

Since hydrogen particles are not emitted during a heat treatment process, the reliability of the first and second active layers 131 and 132 made of oxide semiconductor adjacent to the fifth and sixth insulating layers 125 and 126 can be prevented or protected from being reduced due to hydrogen particles.

The first and second active layers 131 and 132 include an oxide semiconductor material. The oxide semiconductor material can be a combination of at least one metal from among zinc (Zn), indium (In), gallium (Ga), tin (Sn), and titanium (Ti) and an oxide. In some cases, a metal with high conductivity, such as iron (Fe), may be further included in the oxide semiconductor material to increase mobility.

More specifically, examples of the oxide semiconductor material forming the first and second active layers 131 and 132 include zinc oxide (ZnO), zinc-tin oxide (ZTO), zinc-indium oxide (ZIO), indium oxide (InO), titanium oxide (TiO), indium-gallium-zinc oxide (IGZO), indium-zinc-tin oxide (IZTO), and iron-indium-zinc oxide (FIZO).

The seventh insulating layer 127 serving as a gate insulating layer may be disposed between the first and second active layers 131 and 132 and the first and second gate electrodes 133 and 134. The seventh insulating layer 127 may be provided between the first and second active layers 131 and 132 and the first and second gate electrodes 133 and 134, as illustrated, or may be selectively provided only in the channel regions of the first and second active layers 131 and 132.

The seventh insulating layer 127 comprise an inorganic insulating material, and may include, for example, a silicon oxide (SiOx) layer, a silicon nitride (SiNx) layer, or a laminate of inorganic layers.

The channel regions of the first and second active layers 131 and 132 may be regions that are not doped with impurities and may respectively overlap the first and second gate electrodes 133 and 134.

Impurity doped regions in the first and second active layers 131 and 132 may be defined using the first and second gate electrodes 133 and 134 as masks. The impurity doped regions of the first and second active layers 131 and 132 are located on both sides of the first and second gate electrodes 133 and 134, and the doped regions of the first and second active layers 131 and 132 are connected to the source-drain electrodes 137, 141, and 142 spaced apart from each other and can serve as conductive source-drain regions.

The first and second gate electrodes 133 and 134 may comprise a conductive metal material on the seventh insulating layer 127. Specifically, the conductive metal material may include at least one of an aluminum-based metal such as aluminum (Al) or an aluminum alloy, a silver-based metal such as silver (Ag) or a silver alloy, a copper-based metal such as copper (Cu) or a copper alloy, a molybdenum-based metal such as molybdenum (Mo) or a molybdenum alloy, chromium (Cr), tantalum (Ta), neodymium (Nd), or titanium (Ti). The first and second gate electrodes 133 and 134 may have a multilayer structure including at least two conductive metal materials.

The eighth insulating layer 128 may be disposed on the first and second gate electrodes 133 and 134. The eighth insulating layer 128 may cover the upper and side surfaces of the first and second gate electrodes 133 and 134.

The eighth insulating layer 128 may be a single inorganic layer or a laminate of a plurality of inorganic layers. As an inorganic layer, one or more inorganic material layers may be selected from among a silicon oxide (SiOx) layer, a silicon nitride (SiNx) layer, and a silicon oxynitride (SiOxNy) layer.

On the eighth insulating layer 128, the source-drain electrode 137 of the first transistor T1, the connection electrode 136 connecting the first light-shielding pattern 114 of the first transistor T1 and the first gate electrode 133, and the first source-drain electrode 141 and the second source-drain electrode 142 connected to the second active layer 132 of the second transistor T2 may comprise a conductive metal. Further, the first and second connection electrodes 138 and 139 are respectively connected to the first storage electrode 115 and the second storage electrode 118.

In the first transistor T1 illustrated in FIG. 5, the first gate electrode 133 and the first light-shielding pattern 114 are electrically connected by a connection electrode 136. The connection electrode 136 can be overlapped with the first active layer 131 which is disposed between the gate electrode 133 and the first light-shielding pattern 114. The source-drain electrode 137 can be connected to the first active layer 131 while being spaced from the connection electrode 136.

The first source-drain electrode 141 and the second source-drain electrode 142 of the second transistor T2 may be disposed spaced apart from each other with the second gate electrode 134 interposed therebetween. Here, the first and second source-drain electrodes 141 and 142 and the second gate electrode 134 may be disposed in different layers.

The first source-drain electrode 141 may extend to a region away from the second active layer 134 of the second transistor T2 and be connected to the second light-shielding pattern 119 thereunder. In this case, the potential of the second light-shielding pattern 119 can be stabilized.

The source-drain electrode 137, the connection electrode 136, the first and second connection electrodes 138 and 139, the first source-drain electrode 141, and the second source-drain electrode 142 may be made of a conductive metal material. Specifically, the conductive metal material may include at least one of an aluminum-based metal such as aluminum (Al) or an aluminum alloy, a silver-based metal such as silver (Ag) or a silver alloy, a copper-based metal such as copper (Cu) or a copper alloy, a molybdenum-based metal such as molybdenum (Mo) or a molybdenum alloy, chromium (Cr), tantalum (Ta), neodymium (Nd), or titanium (Ti). The source-drain electrode 137, the connection electrode 136, the first and second connection electrodes 138 and 139, the first source-drain electrode 141, and the second source-drain electrode 142 may have a multilayer structure including at least two conductive metal materials.

The first source-drain electrode 141 and the second source-drain electrode 142 are respectively connected to both sides of the channel region of the second active layer 132.

The channel regions of the first and second active layers 131 and 132 are intrinsic regions that are not doped with impurities, and are regions in which carriers move when a voltage is applied to the transistors T1 and T2.

The source-drain electrode 137, the first source-drain electrode 141, and the second source-drain electrode 142 may be directly connected to the first and second active layers 131 and 132 through contact holes positioned in the seventh insulating layer 127 and the eighth insulating layer 128.

The external wiring line 143 may be further provided within the first distance HAA from the end line CEL of the hole H and outside the area surrounded by the dam DM on the same layer as the source-drain electrode 137, the first source-drain electrode 141, and the second source-drain electrode 142.

The first planarization layer 151 may be provided on the connection electrode 136, the source-drain electrode 137, the first source-drain electrode 141, the second source-drain electrode 142, and the first and second connection electrodes 138 and 139 to protect the first and second transistors T1 and T2 and the storage capacitor Cst.

The connection electrode 146 may be further provided on the first planarization layer 151 and may be connected to the second source-drain electrode 142 through a contact hole positioned in the first planarization layer 151. The connection electrode 146 may be made of, for example, a conductive metal material. Specifically, the conductive metal material may include at least one of an aluminum-based metal such as aluminum (Al) or an aluminum alloy, a silver-based metal such as silver (Ag) or a silver alloy, a copper-based metal such as copper (Cu) or a copper alloy, a molybdenum-based metal such as molybdenum (Mo) or a molybdenum alloy, chromium (Cr), tantalum (Ta), neodymium (Nd), or titanium (Ti).

The external wiring 147 may be further provided outside the area surrounded by the dam DM but within the first distance HAA from the end line CEL of the hole H in the same layer as the connection electrode 146, and the metal layer 146A overlapping the first transistor T1 and the storage capacitor Cst may be further provided.

The second planarization layer 152 may be further disposed on the connection electrode 146.

The first electrode 161 is further provided on the second planarization layer 152 and may be connected to the connection electrode 146 through a contact hole in the second planarization layer 152.

The first planarization layer 151 and the second planarization layer 152 are made of an organic insulating material, and may be collectively referred to as a planarization layer PLN in terms of functionality. Since the organic insulating material included in the planarization layer PLN may be relatively vulnerable to external factors such as moisture compared to inorganic insulating materials, the organic insulating material may be removed from the region around the hole H such that the organic insulating material does not directly contact the end line CEL of the hole H. As shown in FIG. 5, the planarization layer PLN may be located outside the dam DM within the first distance HAA around the hole H.

In some cases, the connection electrode 146 may be omitted, and the planarization layer PLN may be configured as a single layer. In this case, the second source-drain electrode 142 may be directly connected to the first electrode 161.

The first electrode 161 may include, for example, a reflective electrode, and may serve to shield light incident on the transistors T1 and T2 below the light-emitting element 160. The first electrode 161 may have a laminated structure of a first transparent electrode, a reflective electrode, and a second transparent electrode, for example. The second transparent electrode, which is the uppermost electrode of the first electrode 161, may lower the barrier for hole injection at the interface with the intermediate layer 162 as a dielectric. Here, the first and second transparent electrodes may be transparent oxide electrodes made of ITO or IZO. The reflective electrode may include silver, a silver alloy such as APC (Ag-Pd-Cu), aluminum, or an aluminum alloy.

The bank 170 is provided to cover the edge of the first electrode 161, and the opening of the bank 170 may be defined as an emission area. The bank 170 may comprise a light-shielding organic insulating material and may have a certain thickness or more. The bank 170 made of a light-shielding organic insulating material may have a thickness of, for example, 1 µm to 5 µm.

The bank material layer 171A of the dam DM may be provided within the first distance HAA in the same layer as the bank 170. Therefore, the bank material layer 171A may include a light-shielding organic insulating material. The bank material layer 171A may be disposed as a component of the dam DM with a certain height. When light is sensed by the sensor SS provided over or under the hole H, the bank material layer 171A can prevent side light dispersed to the side of the hole H from being transmitted to the transistors T1 and T2 of the subpixel SP.

The dam DM may include a spacer material layer 173 in addition to the bank material layer 171A, as shown in FIG. 5. The spacer material layer 173 may include a transparent organic insulating material or a light-shielding organic insulating material. The dam DM in which the bank material layer 171A and the spacer material layer 173 are laminated has a greater height than the surrounding components. Thus, after the dam DM is provided the organic encapsulation layer 182 formed with a liquid material does not flow over the dam DM and can be kept outside the area surrounded by the dam DM or in an area partially overlapping the dam DM.

As shown in FIG. 5, the dam region including the dam DM may include at least a part of the planarization layer PLN in addition to the bank material layer 171A and the spacer material layer 173.

Even if the dam DM is provided at a same layer as at least one of the materials such as the planarization layer PLN and the bank 170, the dam DM is not connected to the planarization layer PLN and the bank 170 in the horizontal direction and is provided as an island within the first distance HAA. Accordingly, when the organic encapsulation layer 182 over the subpixels is spread upon application of the organic encapsulation layer 182, the organic encapsulation layer 182 does not spread beyond the dam DM since the side of the dam DM has a sharp vertical slope.

The dam DM comprises a light-shielding material, such as the material of the bank material layer 171A, to a certain height. When light is sensed by the sensor SS through the hole H, the bank material layer 171A can block a side light spreading to the side of the hole H, thus the dam DM can prevent abnormal operation of the transistors T1 and T2 on the substrate 111 due to the side light. For example, when the side light is transmitted to the transistors T1 and T2, photocurrent may be generated in the active layers 131 and 132, which may lower the stability of the off-state characteristics, or the threshold voltages of the transistors T1 and T2 may fluctuate, which may deteriorate the elements. The light emitting display device according to the present embodiment can prevent the side light caused by the light traveling through the hole H from affecting the elements of the subpixels around the hole H.

In addition, the bank material layer 171A of the dam DM is positioned in the first distance HAA and has a cross section of the undercut UC in which the upper portion protrudes more than the lower portion. Here, the side surface between the upper portion and the lower portion of the bank material layer 171A has a curve. In the cross section of the undercut UC, the undercut with a width of ΔX between the upper surface and the lower surface may cause disconnection of the intermediate layer 162 and/or the second electrode 163 at the dam DM.

The light-emitting element 160 includes the first electrode 161, the intermediate layer 162, and the second electrode 163. After the first electrode 161 is provided, the bank 170 and/or spacers may be provided. Through a same process, the bank material layer 171A and the spacer material layer 173 may be provided within the first distance HAA.

The spacers may be locally disposed on a part of the upper surface of the bank 170 rather than on the overall surface of the bank 170, thereby preventing the bank 170 or the components below the spacers from collapsing when the deposition mask is applied to the substrate 111 during the process of deposition of the intermediate layer 162.

The spacer material layer 173 may be disposed on the bank material layer 171A within the first distance HAA to secure the vertical height of the dam DM such that the material forming the organic encapsulation layer 182 does not flow over the dam DM when the material is spread.

The intermediate layer 162 and the second electrode 163 are sequentially disposed on the substrate 111 having the bank 170 and the dam DM.

The intermediate layer 162 may include a plurality of functional layers along with an emission layer. For example, the intermediate layer 162 may include a hole injection layer, a hole transport layer, an emission layer, an electron transport layer, and an electron injection layer. The intermediate layer 162 may comprise a tandem structure including a plurality of stacks and a charge generation layer between stacks. Each stack may comprise a hole transport layer, an emission layer, and an electron transport layer. The charge generation layer may include, for example, an n-type charge generation layer and a p-type charge generation layer.

Since the subpixels SP display individual colors as components of the light-emitting elements 160, the emission layer may be patterned using a deposition mask having openings corresponding to emission areas of the subpixels and disposed at the subpixels SP.

The functional layers other than the emission layer, such as the hole injection layer, the hole transport layer, the electron transport layer, the electron injection layer, and the charge generation layer, are commonly included in the plurality of subpixels. In addition, the second electrode 163 may also be commonly provided over the plurality of subpixels. These common layers can be formed using a common mask having a common opening for the plurality of subpixels, and the material forming each layer can be provided on the substrate through the common opening. In the light emitting display device of the embodiments of the present disclosure, since at least the bank material layer 171A of the dam DM has the undercut UC in which the lower portion is etched more than the upper portion, the common layers can be separated or disconnected at the undercut UC. The deposition process for forming the common layers may be a vapor deposition process through which common layer forming materials are deposited on the substrate 111. It is difficult to form the common layers on a surface that is not exposed, such as side surfaces of the undercut UC, and thus the common layers are not formed or are very thinly formed at the side surfaces of the undercut DC, resulting in one or more disconnections.

More specifically, although a dummy intermediate layer 162A includingva common layer material and a second electrode material layer 163A may be formed on the upper surface of the bank material layer 171A and the spacer material layer 173, the dummy intermediate layer 162A and the second electrode material layer 163A are not deposited on the side surfaces of the undercut UC of the bank material layer 171A and even if deposited, disconnection may occur. Therefore, the dummy intermediate layer 162A and the second electrode material layer 163A disposed on the dam DM are dummy material layers ELD and are separated from the intermediate layer 162 and the second electrode 163 around the dam DM. In this way, the intermediate layer 162 and the second electrode 163 are separated according to the dam DM including the bank material layer 171A having an undercut.

The second electrode 163 may be a transmissive electrode made of ITO or IZO, or a thin reflective transmissive electrode made of silver, a silver alloy, magnesium, a magnesium alloy, ytterbium (Yb), or an ytterbium alloy.

A capping layer (not shown) is further disposed on the second electrode 163 to protect the second electrode 163 of the light-emitting element 160 and increase the light-emitting efficiency.

The encapsulation layer 180 is provided on the second electrode 163 to prevent moisture penetration into the internal components and protect the internal components from the outside air.

The encapsulation layer 180 may have, for example, a structure in which the first inorganic encapsulation layer 181, the organic encapsulation layer 182, and the second inorganic encapsulation layer 183 are laminated. The display device according to the embodiment of the present disclosure is not limited to the illustrated configuration. In this case, the organic encapsulation layer 182 is thicker than the first and second inorganic encapsulation layers 181 and 183, and thus when the organic encapsulation layer 182 remains around the hole H, laser cutting along the end line CEL of the hole H may be difficult. In addition, when the organic encapsulation layer is disposed to extend to the hole H, the organic encapsulation layer may be directly affected by the hole H through which the outside air directly enters. Therefore, the organic encapsulation layer 182 in embodiments of the present disclosure is disposed outside the dam region having the dam DM and positioned at a certain distance from the end line CEL of the hole by defining a formation region of the organic encapsulation layer 182. The end line of the organic encapsulation layer 182 may overlap the dam region or be next to the dam region within the first distance HAA. The end line of the organic encapsulation layer 182 adjacent to the hole H may be positioned at an area having a sharp vertical step due to the dam DM around the dam DM or may be positioned to partially overlap with the dam DM.

In some cases, the encapsulation layer 180 may be replaced with an encapsulation substrate such as glass. The encapsulation substrate may further have an adhesive layer provided between the encapsulation substrate and the light-emitting element 160 facing the encapsulation substrate.

FIG. 5 shows a configuration in which a touch sensor including a first touch electrode layer 201 and a second touch electrode layer 202e and 203 is disposed on or over the encapsulation layer 180.

The touch sensor is disposed on the encapsulation layer 180 in the active area AA and can sense a touch input. The touch sensor can detect external touch information using a user's finger or a touch pen. The touch sensor may include a touch buffer layer 204, the first touch electrode layer 201, a touch intermediate insulating layer 205, the second touch electrode layer 202e and 203, and a touch protective layer 206.

The touch buffer layer 204 and the touch intermediate insulating layer 205 may be made of an inorganic material such as silicon nitride (SiNx), silicon oxide (SiOx), silicon oxynitride (SiONx), and the like, and the embodiments of the present disclosure are not limited thereto.

The first touch electrode layer 201 and a second touch connection electrode 202e located on different layers in the touch sensor may be connected to each other and used as a first touch sensor Tx. The second touch electrode layer 203 separated from the second touch connection electrode 202e may be electrically separated from the first touch sensor Tx and used as a second touch sensor Rx. A touch sensing signal may be applied to one of the first touch sensor Tx and the second touch sensor Rx, and a change according to touch may be sensed through the other.

The first and second touch sensors Tx and Rx may be disposed to overlap the bank 170. For example, the first touch sensor Tx may be disposed in the X-axis direction, and the second touch sensor Rx may be disposed in the Y-axis direction. Alternatively, the first and second touch sensors Tx and Rx may be disposed in the Y-axis direction and the X-axis direction, respectively.

The first and second touch electrode layers 201, 202e and 203 may be made of a metal material, but the present disclosure is not limited thereto.

A connecting touch line 203m may be further provided in an area overlapping the first distance HAA using the same material as any one of the first and second touch electrode layers 201, 202e and 203. The connecting touch line 202m may be connected to any one of the first and second touch sensors Tx and Rx around the dam region surrounding the hole H. In some cases, the connecting touch line 202m may be further provided on the dam DM.

In an embodiment of FIG. 5, the display device comprises the dam DM which comprises the bank material layer 171A comprising a light-shielding organic insulating material and the spacer material layer 173 stacked. The thickness of the dam DM may be adjusted by appropriately including the planarization layer PLN, the bank 170 and/or the spacers.

A light-shielding layer 191 overlapping the bank 170 and a color filter layer 192 overlapping the opening of the bank 170, i.e., the emission area, may be provided on the encapsulation layer 180. The color filter layer 192 may be disposed to be wider than the emission area to overlap the light-shielding layer 191 at the area overlapping the bank 170.

The light-shielding layer 191 and the color filter layer 192 on the encapsulation layer 180 serve to prevent external light from being visible together by replacing a polarizing plate. The light-shielding layer 191 can prevent external light transmission in the visible spectrum. The color filter layer 192 has selective transmittance according to the wavelength of the color emitted from the subpixel. For example, the color filter layer 192 may include a red color filter, a green color filter, and a blue color filter respectively corresponding to the subpixels SP.

The light-shielding layer 191 includes a light-shielding organic insulating material and has a constant thickness to effectively block transmission of external light or side light.

Hereinafter, a method of forming the bank material layer 171A according to an embodiment of the present disclosure will be described.

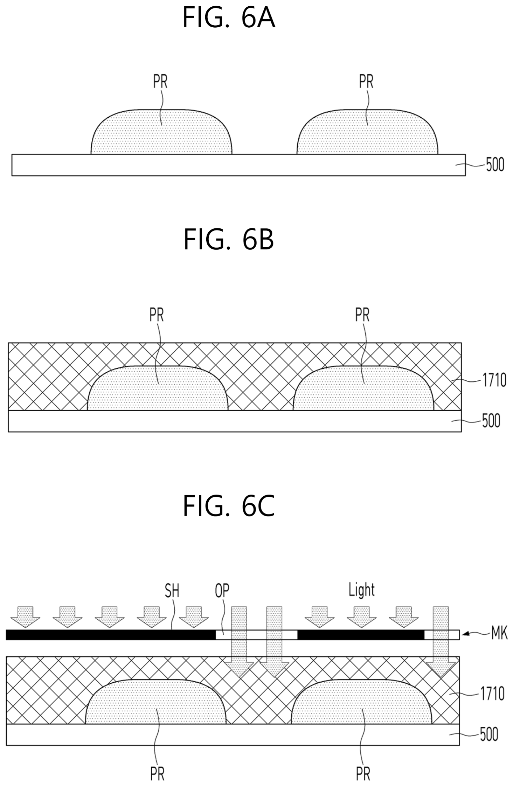

FIG. 6A to FIG. 6F are cross-sectional views showing a process of a method for forming the bank material layer of the dam of the light emitting display device of the present disclosure.

As shown in FIG. 6A, a photoresist layer PR is selectively applied on a substrate 500.

Here, the substrate 500 is provided with the first electrode 161 along with the first and second transistors T1 and T2, the storage capacitor Cst, the insulating layer 120, and the planarization layer PLN on the substrate 111 of FIG. 5.

The photoresist layer PR has a curved shape on the side to form the curve between the upper portion and the lower portion of the undercut of the bank material layer 171A to be formed later.

Then, as shown in FIG. 6B, a bank material 1710 is applied on the entire surface of the substrate 500 including the photoresist layer PR. The bank material 1710 may a light-shielding organic insulating material and the surface thereof can be planarized.

As shown in FIG. 6C, a mask MK having an opening OP at a predetermined portion and a light-shielding portion SH at a portion other than the opening OP is placed above the bank material 1710.

The mask MK is placed such that the opening OP corresponds to an area between adjacent photoresist layers PR.

Light is radiated to the bank material 1710 through the opening OP of the mask MK to harden the bank material 1710.

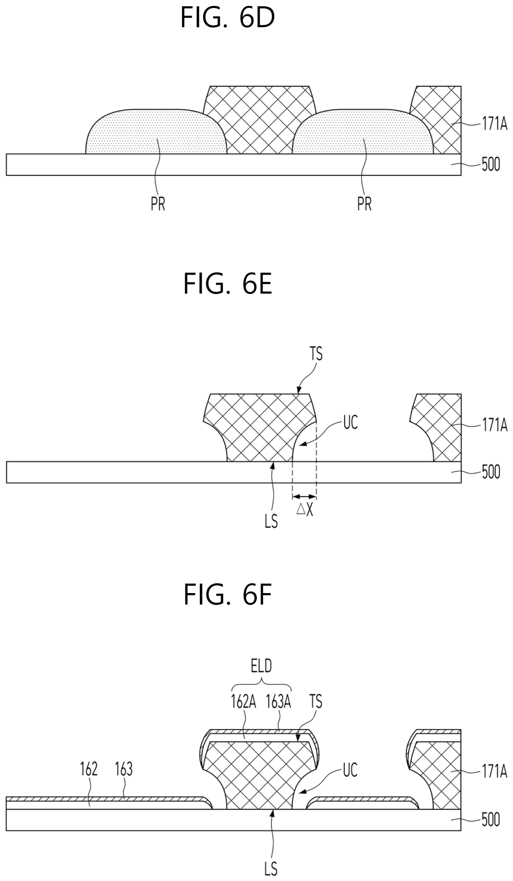

As shown in FIG. 6D, a developer is applied to the bank material 1710 to remove the unexposed portions of the bank material 1710 to form a patterned bank material layer 171A.

As shown in FIG. 6E, the photoresist layer PR is removed to leave the bank material layer 171A on the substrate 500. Here, the bank material layer 171A has an undercut UC between the upper surface TS and the lower surface LS.

The curved side of the photoresist layer PR can serve to form the undercut UC between the upper surface and the lower surface of the bank material layer 171A.

When the intermediate layer 162 and the second electrode 163 are formed at the area where the bank material layer 171A having such an undercut is disposed, as shown in FIG. 6F, the intermediate layer 162 and the second electrode 163 are sequentially deposited in the planarized area on the substrate 500, but the dummy intermediate layer 162A and the second electrode material layer 163A are not formed in the area of the undercut UC, and thus the dummy intermediate layer 162A and the second electrode material layer 163A are separated and remain as a dummy layer ELD on the bank material layer 171A.

FIG. 6A to FIG. 6F show an example in which the dam is formed using only the bank material layer 171A. As in the embodiment of FIG. 5, even when the dam includes the spacer material layer on the bank material layer 171A, the bank material layer 171A also has the undercut UC, and thus the dummy intermediate layer 162A and the second electrode material layer 163A on the dam can be separated from the intermediate layer 162 and the second electrode 163.

In addition, in light emitting display devices according to other embodiments which will be described below, the bank material layer also has an undercut, and thus the intermediate layer 162 and the second electrode 163 can be disconnected in the undercut of the bank material layer.

In the embodiments which will be described below, descriptions of the same components as the embodiment of FIG. 5 described above are omitted.

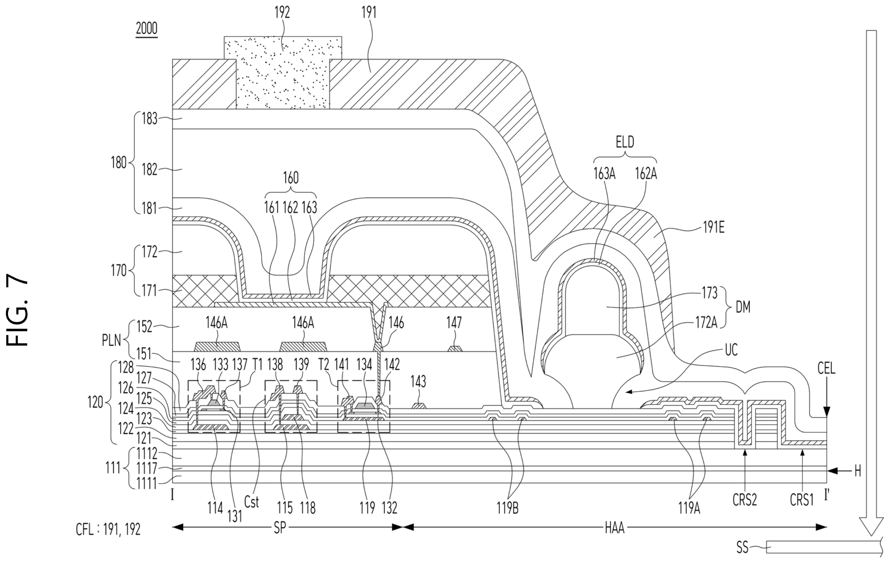

FIG. 7 to FIG. 10 are cross-sectional views of light emitting display devices according to other embodiments of the present disclosure, taken along line I-I' in FIG. 2.

In the light emitting display device 2000 according to an embodiment of the present disclosure shown in FIG. 7, a bank 170 includes a double layer of a light-shielding bank layer 171 and a transparent bank layer 172. The light-shielding bank layer 171 can prevent color mixing between subpixels and prevent external light from being visible.

The transparent bank layer 172 can protect the light-shielding bank layer 171. The transparent bank layer 172 can also serve as a spacer.

The dam region including the dam DM is positioned within the first distance HAA around the hole H and is provided spaced apart from the bank 170. The dam region may include the dam DM comprising a bank material layer 172A and a spacer material layer 173. The bank material layer 172A may be provided in the same layer as the transparent bank layer 172.

Due to the steep slope of the side of the dam DM, the organic encapsulation layer 182 of the encapsulation layer 180 does not reach the dam DM, and the organic encapsulation layer 182 can be disposed to be spaced apart from the end line CEL of the hole H.

A light-shielding layer 191 overlapping the bank 170 and a color filter layer 192 corresponding to the opening of the bank 170, i.e., the emission area, may be provided on the encapsulation layer 180. The color filter layer 192 may be disposed wider than the emission area to overlap the light-shielding layer 191 in the area overlapping the bank 170.

The light-shielding layer 191 and the color filter layer 192 provided on the encapsulation layer 180 serve to prevent external light from being visible together by replacing a polarizing plate. The light-shielding layer 191 can prevent external light transmission in the visible spectrum. The color filter layer 192 has selective transmittance according to the wavelength of the color emitted from the subpixel. For example, the color filter layer 192 may include a red color filter, a green color filter, and a blue color filter respectively corresponding to the subpixels SP.

The light-shielding layer 191 includes a light-shielding organic insulating material and has a constant thickness to effectively block transmission of external light or side light.

In the light emitting display device of the embodiment shown in FIG. 7, the light-shielding layer 191 has a light-shielding layer extension 191E that extends from the subpixels SP to the first distance HAA around the hole H and overlaps the upper surface and the side surface of the dam DM. The light-shielding layer extension 191E overlaps the dam DM and is disposed above the dam DM within the first distance HAA. Specifically, the light-shielding layer extension 191E may be disposed to be in contact with the second inorganic encapsulation layer 183 of the encapsulation layer 180. Here, the first inorganic encapsulation layer 181 and the second inorganic encapsulation layer 183 are disposed to cover the upper surface and the side surface of the dam DM, and the light-shielding layer extension 191E is located to cover the second inorganic encapsulation layer 183 that covers the upper surface and the side surface of the dam DM adjacent to the hole H. Accordingly, even if light is incident on the sensor SS through the hole H, the light-shielding layer extension 191E can prevent the sensed light from being dispersed to the side and transmitted to the transistors T1 and T2 on the substrate 111.

The dam DM at the dam region is used to disconnect the intermediate layer 162 and the second electrode 163 within the first distance HAA and prevents the organic encapsulation layer 182 from overflowing when the organic encapsulation layer is applied. In addition, when external light enters the sensor SS, side light caused thereby can be blocked by the light-shielding organic insulating material of the light-shielding layer extension 191E overlapping the dam DM.

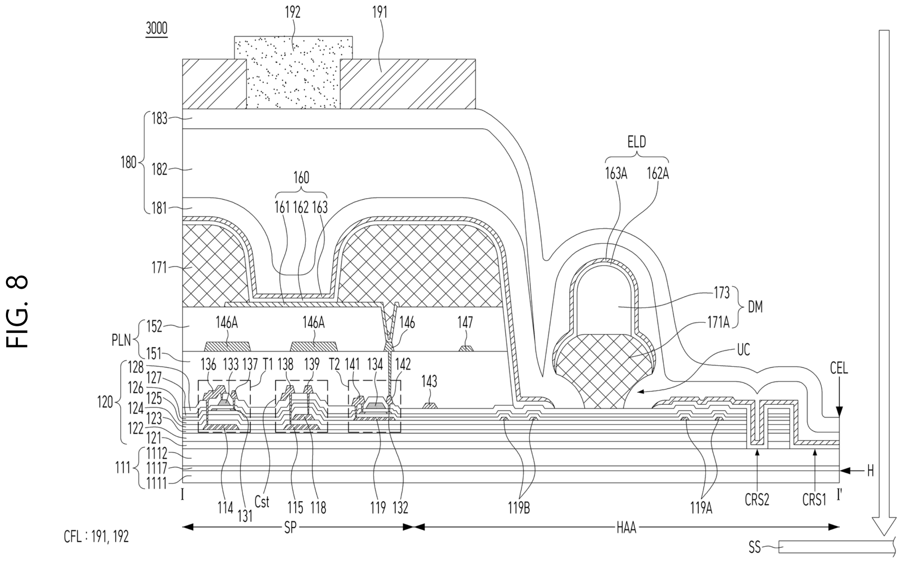

In the light emitting display device 3000 shown in FIG. 8, a bank 171 may have a light-shielding organic insulating material, and the dam DM disposed around the hole H may comprise a bank material layer 171A and a spacer material layer 173 stacked. In the light emitting display device shown in FIG. 8, a light-shielding layer 191 may be disposed corresponding to the bank 171 at the subpixel SP.

The dam DM is used to disconnect the intermediate layer 162 and the second electrode 163 within the first distance HAA and prevents the organic encapsulation layer 182 from overflowing when the organic encapsulation layer is applied. In addition, when the external light enters the sensor SS, side light caused thereby can be blocked by the bank material layer 171A made of a light-blocking organic insulating material forming the dam DM.

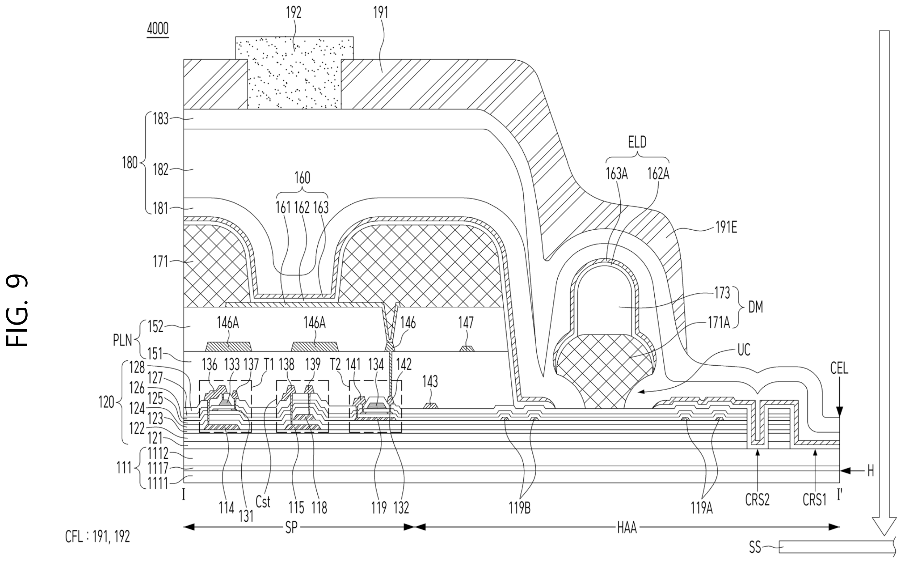

In the light emitting display device 4000 shown in FIG. 9, the dam region comprises the dam DM having a light shielding material and another light shielding material over the dam DM.

A bank 171 may comprise a light-shielding organic insulating material. The dam region is disposed around the hole H and comprises a dam DM including a bank material layer 171A and a spacer material layer 173, and a light-shielding layer extension 191E over the first distance HAA. An upper surface and a side of the dam DM may overlap with the light-shielding layer extension 191E within the first distance HAA. In the light emitting display device shown in FIG. 9, the light-shielding layer 191 may be provided corresponding to the bank 171 at the subpixel SP.

The dam DM is used to disconnect the intermediate layer 162 and the second electrode 163 at the first distance HAA and prevents the organic encapsulation layer 182 from overflowing when the organic encapsulation layer is applied. In addition, when external light enters the sensor SS, side light caused thereby can be blocked by the bank material layer 171A made of the light-shielding organic insulating material forming the dam DM.

The light-shielding layer extension 191E effectively blocks side light incident on the hole H together with the bank material layer 171A when light is transmitted from above the substrate to the sensor SS, thereby preventing abnormal operation of the transistors T1 and T2 of the subpixels SP adjacent to the hole H, stabilizing the threshold voltage characteristics, and improving the reliability of the device.

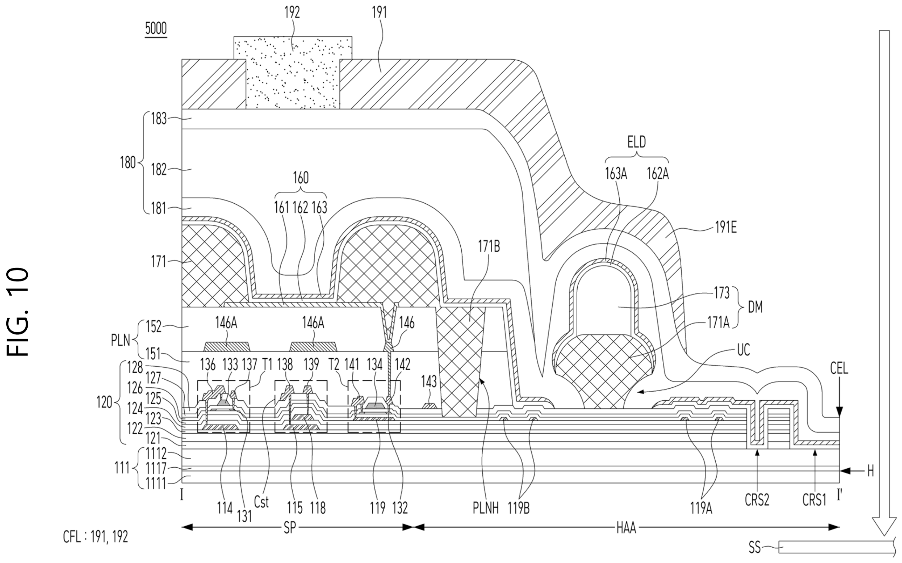

As shown in FIG. 10, an embodiment of the light emitting display device 5000 may comprise the dam DM and the light-shielding layer extension 191E over the dam DM. The light-shielding layer extension 191E is an extended structure from the light shielding layer 191. Also, a trench PLNH is provided in the planarization layer PLN, the seventh insulating layer 127, and the eighth insulating layer 128 within the first distance HAA away from the end line CEL of the hole H. The trench PLNH is spaced from the dam DM and is an independent structure from the dam DM. The trench PLNH is filled with a light-shielding organic insulating material 171B forming the bank 171.

Here, the trench PLNH may have a side surface adjacent to the active layers 131 and 132.

The light-shielding organic insulating material 171B filling the trench PLNH can effectively block side light generated when external light is incident on the sensor SS when light sensing is performed in the sensor SS together with the bank material layer 171A of the dam DM and the light-shielding layer extension 191E, thereby improving the reliability of the elements disposed on the substrate 111.

The light emitting display devices according to the embodiments of the present disclosure include the dam at which the light-emitting element 160 is disconnected, which is disposed around the hole H of the substrate 111 corresponding to the sensor, thereby preventing external air or moisture from entering through the hole H of the substrate 111 from affecting the subpixels.

The light emitting display devices according to the embodiments of the present disclosure include the light-shielding bank material layer 171A around the hole H of the substrate 111 provided to receive external light, and thus can prevent external light entering the hole H from being dispersed and transmitted to subpixels located outside the bank material layer 171A. Accordingly, the operational reliability of the components such as the transistors T1 and T2 provided at the subpixels SP can be secured.

In the light emitting display devices according to the embodiments of the present disclosure, the dam DM for separating the organic encapsulation layer 182 from the hole H includes the bank material layer 171A made of a light-shielding material, or the light-shielding layer extension 191E is disposed to overlap the dam DM to prevent external light from being incident on components laterally adjacent to the hole.

Accordingly, it is possible to prevent deterioration of components, thereby reducing a defect rate, and to achieve ESG (Environmental/Social/Governance) by reducing production energy through process optimization.

Meanwhile, the light emitting display device of FIG. 5 may further include a light-shielding layer 191 corresponding to the bank 170 and a color filter layer 192 corresponding to the opening of the bank 170 on the touch protection layer 206. In addition, the light-shielding layer 191 may further include a light-shielding layer extension 191E to overlap the second inorganic encapsulation layer 183 covering the upper surface and the side of the dam DM. Accordingly, when light propagates through the hole H, the side light caused by this can be prevented from affecting the transistors T1 and T2 at subpixels SP around the hole H.

According to an aspect of the present disclosure, a light emitting display device comprises a substrate including an active area having a hole and a non-active area surrounding the active area, a plurality of subpixels in the active area, the plurality of subpixels spaced apart from the hole by a first distance, a transistor at each of the plurality of subpixels, a light-emitting element including a first electrode provided at each of the plurality of subpixels and connected to the transistor, a second electrode facing the first electrode, and an intermediate layer interposed between the first electrode and the second electrode and a dam region to surround the hole within the first distance, the dam region including a bank material layer having an undercut. The dam region may comprise at least one light-shielding material among the bank material layer and an upper structure overlapping the bank material layer.

According to an aspect of the present disclosure, a light emitting display device comprises a substrate including an active area having a hole and a non-active area surrounding the active area; a plurality of subpixels in the active area, the plurality of subpixels spaced apart from the hole by a first distance, wherein a light-emitting element is provided at each of the plurality of subpixels and includes a first electrode, a second electrode, and an intermediate layer interposed between the first electrode and the second electrode; and a dam region. The dam region may be surrounding the hole within the first distance. The dam region may include a dam, the dam having an undercut. The dam region or the dam may include a bank material layer having an undercut. The dam region may comprise at least one light-shielding material among the bank material layer and an upper structure overlapping the bank material layer. That is, in the dam region, a light-shielding material is disposed, e.g. around the hole. The light-shielding material may be included in the bank material layer and/or in the dam and/or in a layer disposed on and/or above the dam.

The light emitting display device (or display device) according to any one of these aspects may include one or more of the following features:

A transistor may be provided at/in each of the plurality of subpixels. The first electrode of the subpixels may be connected to the respective transistor. The intermediate layer may include a (light) emission layer.

The plurality of subpixels may be spaced apart from an edge or end line of the hole by the first distance. The end line may be denoted as edge or circumferential line or circumference of the hole. The first distance may be defined as a distance perpendicular to the end line. A region between the end line of the hole and the first distance, i.e. a region defined by the first distance from the end line, may include the dam region.

The dam may include the bank material layer. The dam may include the bank material layer and a spacer material layer. The dam may include a light-shielding material, e.g. the bank material layer may include or be a light-shielding material. The dam may (fully) surround the hole. The light-shielding material may be disposed around the hole. The dam may be disposed at a distance less than the first distance to the hole. The dam may be disposed between the plurality of subpixels and the hole.

The dam may include the undercut. The undercut may be formed in the bank material layer. "Undercut" may denote a portion of the bank material layer being closer to the substrate and having a smaller width than a portion of the bank material layer being further apart and having a wider width. That is, the bank material layer in the dam region may have a mushroom shape (e.g. at least in cross-section perpendicular to the substrate).

The upper structure overlapping the bank material layer may include or be a/the layer disposed on/above the dam. The upper structure and/or the layer may include at least one of an insulating layer, an encapsulation layer and a light-shielding layer.

The dam and/or the bank material layer may include a light-shielding organic material.

The intermediate layer may be separated from the bank material layer in the area of the undercut of a sectional view. The intermediate layer may be separated and/or disconnected by the undercut.

The light emitting display device may further comprise a bank. The bank may be exposing an emission area of the plurality of subpixels. The bank may be exposing an emission area of the first electrode at each of the plurality of subpixels. The dam may include a bank material layer being of a same material as a layer or a material of the bank. The bank material layer in the dam region may have a different cross-section than the bank. The bank material layer of the dam region may include same material as the bank and/or may have a different cross section from the bank.

The bank may include a light-shielding bank. The bank material layer in the dam region may be or include the same material as the light-shielding bank.

The light emitting display device may comprise a transparent bank in contact with the light-shielding bank.

The light emitting display device may comprise an encapsulation layer covering the light-emitting element. The light emitting display device may comprise a light-shielding layer overlapping the bank and/or a color filter layer overlapping the emission area. The light-shielding layer and/or the color filter layer may disposed on the encapsulation layer.

The dam region or the dam may include a spacer material layer, e.g. on the bank material layer. The dam and/or the bank material layer and/or the spacer material layer may surround the hole. The light emitting display device may comprise a spacer, the spacer material layer of the dam and/or in the dam region including a same material as the spacer.

The light-shielding layer may comprise a light-shielding layer extension extending into the first distance. The light-shielding layer extension may be overlapped with the bank material layer and/or may be laterally closer to the hole than the bank material layer. The light-shielding layer extension may overlap the dam.

The encapsulation layer may include an inorganic encapsulation layer and/or an organic encapsulation layer. The dam region or the dam may further include a spacer material layer on the bank material layer. The inorganic encapsulation layer may cover an upper surface and/or a side of the spacer material layer at/in the dam region. The light-shielding layer may be disposed to cover the inorganic encapsulation layer.

The bank material layer may have a width shorter in a lower portion than in an upper portion. The bank material layer may have a curve between the upper portion and the lower portion of the bank material layer. The undercut portion of the bank material layer may be curved.

The light emitting display device may comprise a crack prevention part defined by removing a plurality of inorganic insulating layers and disposed between the hole and the dam region. The light emitting display device may comprise a crack prevention part between the hole and the dam region. The crack prevention part may be defined by removing a plurality of inorganic insulating layers. The crack prevention part may be a part exposed by any/all inorganic insulating layers and/or in which all inorganic insulating layers are removed.

The light-shielding layer and/or the color filter layer may not overlap the crack prevention part at least within the first distance. The light-shielding layer and/or the color filter layer may expose the crack prevention part, in particular at least in an area within the first distance.

The transistor may include at least one of an active layer, a gate electrode, and first and second source-drain electrodes. A gate insulating layer may be provided between the active layer and the gate electrode. An interlayer insulating layer may be provided between the gate electrode and the first and second source-drain electrodes. A planarization layer may be provided between the first and second source-drain electrodes and the first electrode, on the substrate. At least one or some or all of the gate insulating layer, the interlayer insulating layer, and the planarization layer may include a trench outside the dam region, the trench being filled with a light-shielding material.

The light emitting display device may include a transistor in each of the plurality of subpixels. The light emitting display device may include at least one insulating layer, e.g. a gate insulating layer, an interlayer insulating layer and/or a planarization layer. The at least one insulating layer may include a trench in the area within the first distance and/or outside the dam region. The at least one insulating layer may include a trench between the dam region and a region in which the plurality of subpixels is disposed. The trench may be filled with a light-shielding material.

The active layer may include an oxide semiconductor.

The light emitting display device may include an encapsulation layer covering the light-emitting element. The trench may overlap a light-shielding layer on an encapsulation layer covering the light-emitting element.

The light emitting display device may comprise a wiring layer at a same layer as at least one electrode of the transistor around the dam region, the wiring layer parallel to the bank material layer. The wiring layer may be disposed between the hole and the dam and/or between the dam and the plurality of subpixels and/or in the area within the first distance. The wiring layer may surround the dam and/or the dam region and/or the hole. The wiring layer may extend in parallel to the dam.

The bank material layer of the dam region may be wider than the wiring layer parallel to the bank material layer.

The light emitting display device may comprise a sensor or a camera under the substrate and overlapping the hole. The sensor or camera may be disposed below the substrate at a position corresponding to the hole. The sensor or camera may be exposed by the hole.

The light emitting display device may comprise an encapsulation layer covering the light-emitting element. The light emitting display device may comprise a touch sensor including a plurality of touch electrodes disposed on the encapsulation layer.

The light emitting display device of the present disclosure has the following advantages.

The light emitting display device according to embodiments of the present disclosure may include a disconnection part of a light-emitting element around a hole of the substrate corresponding to a sensor, thereby preventing the influence of external air or moisture through the hole of the substrate on subpixels. The disconnection part may be formed by the undercut.

The light emitting display device according to the embodiments of the present disclosure may include a light-shielding material, e.g. a light-shielding bank material layer, around the hole of the substrate provided to receive external light, thereby preventing external light entering through the hole from being transmitted to the subpixels located outside the bank material layer and ensuring the operational reliability of elements such as transistors provided in the subpixels.

The light emitting display device according to the embodiments of the present disclosure may include a dam including a light-shielding material which separates an organic encapsulation layer from the hole, thereby preventing external light from being incident laterally on the components adjacent to the hole.

The light emitting display device according to the embodiments of the present disclosure can prevent deterioration of components, thereby reducing a defect rate, and achieve ESG (Environments/Social/Governance) by reducing production energy through process optimization.

It will be apparent to those skilled in the art that various modifications and variations can be made in the present disclosure without departing from the spirit or scope of the present disclosure. Thus, it is intended that the present disclosure cover the modifications and variations of the present disclosure provided they come within the scope of the appended claims and their equivalents.

## Claims

1. A light emitting display device comprising:
a substrate (111) including an active area (AA) having a hole (H) and a non-active area (NA) surrounding the active area (AA);
a plurality of subpixels (SP) in the active area (AA), the plurality of subpixels (SP) spaced apart from the hole (H) by a first distance (HAA);
a light-emitting element (160) provided at each of the plurality of subpixels and including a first electrode (161), a second electrode (163), and an intermediate layer (162) interposed between the first electrode (161) and the second electrode (163); and
a dam region surrounding the hole (H) in an area within the first distance (HAA), the dam region (DM) including a dam (DM) having an undercut (UC),
wherein in the dam region, a light-shielding material is disposed around the hole (H) and/or included in at least one of the dam (DM) and a layer disposed on the dam (DM).

2. The light emitting display device of claim 1, wherein the dam (DM) includes a light-shielding organic material.

3. The light emitting display device according to any one of the preceding claims, wherein the intermediate layer (162) is disconnected by the undercut (UC).

4. The light emitting display device according to any one of the preceding claims, further comprising a bank (170) exposing an emission area of the plurality of subpixels (SP),
wherein the dam (DM) includes a bank material layer being of a same material as the bank (170).

5. The light emitting display device of claim 4, wherein the bank (170) includes a light-shielding bank (171); or
wherein the bank (170) includes a light-shielding bank (171) and a transparent bank (172) in contact with the light-shielding bank (171).

6. The light emitting display device of claim 4 or 5, further comprising an encapsulation layer (180) covering the light-emitting element (160); and
a light-shielding layer (191) overlapping the bank (170) and/or a color filter layer (192) corresponding to the emission area, on the encapsulation layer (180).

7. The light emitting display device of claim 6, wherein:
the light-shielding layer (191) comprises a light-shielding layer extension (191E) extending into the area within the first distance (HAA), and
the light-shielding layer extension (191E) overlaps the dam (DM) and/or is laterally closer to the hole (H) than the dam (DM).

8. The light emitting display device of claim 6 or 7, wherein the encapsulation layer (180) includes an inorganic encapsulation layer (181, 183) and an organic encapsulation layer (182),
the dam (DM) includes a spacer material layer (173) on the bank material layer (171a),
the inorganic encapsulation layer (181, 183) covers an upper surface and a side of the spacer material layer (173) in the dam region, and
the light-shielding layer (191) covers the inorganic encapsulation layer (181, 183).

9. The light emitting display device of claim 6, 7 or 8, further comprising a crack prevention part (CRS1, CRS2) between the hole (H) and the dam region, wherein the light-shielding layer (191) and/or the color filter layer (192) expose the crack prevention part (CRS1, CRS2).

10. The light emitting display device according to any one of the preceding claims, further comprising:
at least one insulating layer (123, 124), in particular at least one of a gate insulating layer (123), an interlayer insulating layer (124) and a planarization layer (151, 152);
wherein the at least one insulating layer (123, 124) includes a trench (PLNH) outside the dam region and/or in the area within the first distance (HAA), the trench (PLNH) being filled with a light-shielding material (171B).

11. The light emitting display device of claim 10, wherein the trench (PLNH) overlaps a light-shielding layer (191) on an encapsulation layer (180) covering the light-emitting element (160).

12. The light emitting display device according to any one of the preceding claims, further comprising a wiring layer (119a) at a same layer as at least one electrode of a transistor (T1, T2) disposed at each of the plurality of subpixels (SP), and
wherein the wiring layer (119a, 119b) is disposed between the hole (H) and the dam (DM) and/or between the dam (DM) and the plurality of subpixels (SP), and/or
wherein the wiring layer (119a, 119b) is disposed in parallel to the dam (DM).

13. The light emitting display device of claim 12, wherein the dam (DM) is wider than the wiring layer (119a, 119b) parallel to the dam (DM).

14. The light emitting display device according to any one of the preceding claims, further comprising a sensor or a camera under the substrate (110) and overlapping the hole (H).

15. The light emitting display device according to any one of the preceding claims, further comprising:
an encapsulation layer (180) covering the light-emitting element (160); and
a touch sensor including a plurality of touch electrodes disposed on the encapsulation layer (180).
